Europäisches Patentamt

European Patent Office

Office européen des brevets

(19)

(11) Veröffentlichungsnummer: **0 140 086**
A2

(12) **EUROPÄISCHE PATENTANMELDUNG**

(21) Anmeldenummer: **84110823.6**

(22) Anmeldetag: **11.09.84**

(51) Int. Cl.⁴: **H 03 M 1/80**

(30) Priorität: **20.09.83 DE 3333934**

(43) Veröffentlichungstag der Anmeldung:
**08.05.85 Patentblatt 85/19**

(84) Benannte Vertragsstaaten:
**AT DE FR GB IT**

(71) Anmelder: **Siemens Aktiengesellschaft
Berlin und München Wittelsbacherplatz 2
D-8000 München 2(DE)**

(72) Erfinder: **Luschnig, Werner, Dipl.-Ing.
Rudolfweg 32
A-9524 Magdalen(AT)**

(54) **Integrierter Digital/Analogwandler.**

(57) Aufgabe der Erfindung ist es, einen mit gewichteten Konstantstromquellentransistoren arbeitendnen D/A-Wandler zu schaffen, der einerseits eine kompakte Integrierung auch bei einer größeren Anzahl von Wandlerstufen erlaubt und dabei temperaturunempfindlich arbeitet. Erreicht wird dieses Ziel, indem die vorgesehenen Wandlerstufen in zwei Gruppen unterteilt sind, wobei die zu der ersten Gruppe gehörenden Stromquellentransistoren sowohl bezüglich ihrer Emittervorwiderstände als auch bezüglich ihrer Emitterflächen dual gewichtet sind, während bei der den niedrigen Bitwertigkeiten angehörenden zweiten Gruppe von Wandlerstufen sich die duale Wichtung auf die Emittervorwiderstände beschränkt, während die Emitterflächen der Stromquellentransistoren dieser Gruppe alle gleich bemessen sind und dem Stromquellentransistor der niedrigsten Bitwertigkeit in der ersten Gruppe von Wandlerstufen entsprechen. Um dennoch die Temperaturunempfindlichkeit zu erreichen, werden von dem Referenzstromkreisausgang die Basen der Stromquellentransistoren in unterschiedlicher Weise gesteuert, wozu jeder Gruppe Vermittlungstransistoren und je eine Konstantstromquelle zugeordnet sind.

FIG 2

0140088

Siemens Aktiengesellschaft   Unser Zeichen
Berlin und München          VPA 83 P 5302 E

## Integrierbarer Digital/Analogwandler

Die Erfindung betrifft einen integrierbaren Digital/Analogwandler in Bipolartechnik, bei dem jedem Bit des zu verarbeitenden digitalen Datensignals je eine aus einem als
Konstantstromquelle betriebenen Transistor und aus einem
Umschalter bestehende Stufe zugeordnet ist und die einzelnen Wandlerstufen derart ausgebildet sind, daß beim Zustand logisch "1" des die betreffende Stufe beaufschlagenden Bits der den Ausgang der Konstantstromquelle bildende
Kollektor des Stromquellentransistors an den Signalausgang
des Wandlers und beim Zustand logisch "0" dieses Bits an
einen gemeinsamen anderen Anschluß, z.B. an die Versorgungsklemme für das Bezugspotential, gelegt wird, bei
dem ferner der vom Stromquellentransistor an den zugehörigen Umschalter in den vorgesehenen Stufen des Wandlers nach
Maßgabe der Bitwertigkeit des die einzelne Stufe beaufschlagenden Bits in dem auszuwertenden digitalen Datenwort durch
entsprechende unterschiedliche Bemessung des den Emitter des
Stromquellentransistors mit der Versorgungsklemme für das
Emitterpotential $V_{EE}$ des Wandlers verbindenden Emittervorwiderstands eine dieser Bitwertigkeit entsprechende Wichtung erhält, und bei dem schließlich die Stromquellentransistoren in den vorgesehenen Stufen des Wandlers zwar bezüglich der Dotierung von Emitter, Basis und Kollektor
übereinstimmen, während andererseits auch eine Wichtung
hinsichtlich der Emitterfläche der Stromquellentransistoren - und zwar im gleichen Sinn wie die Wichtung des von
dem Stromquellentransistor gelieferten Konstantstroms -
vorgesehen ist.

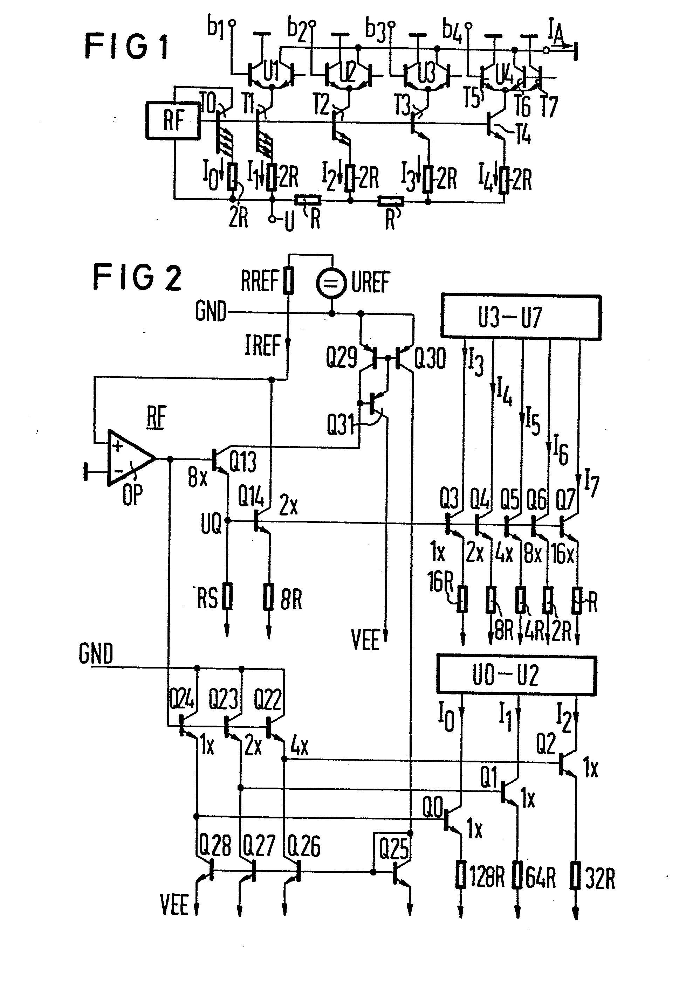

Eine derartige Ausgestaltung für einen Digital/Analogwandler ist in der Literaturstelle "Elektronik (1977) Heft 3,
S. 38 ff." (vgl. insbesondere S. 40) beschrieben. Eine
entsprechende Schaltung ist in Fig. 1 dargestellt, auf die
zunächst eingegangen werden soll.

Bei Digital/Analogwandlern, die mit gewichteten Konstant-strömen arbeiten, kann man die Wichtung entweder durch Parallelschaltung einer der jeweiligen Wichtung entsprechenden Zahl einander gleicher und in identischer Weise gesteuerter Transistoren erreichen. Einfacher ist es jedoch, die Stromquellentransistoren in gleicher Weise zu bemessen und die Wichtung durch entsprechende Bemessung der Emittervorwiderstände der einzelnen Stromquellentransistoren zu erreichen, was am einfachsten durch ein geeignetes Widerstandsnetzwerk, z.B. ein R/2R-Netzwerk, gelingt, welches die Emitter der Stromquellentransistoren mit dem das Emitterpotential $V_{EE}$ liefernden Versorgungsanschluß verbindet.

Bei der in Fig. 1 dargestellten Schaltung für einen D/A-Wandler sind vier Konstantstromquellen TO - T4 vorgesehen, die durch je einen Transistor (im Beispielsfalle sind ausschließlich npn-Transistoren verwendet) gegeben sind, so daß der gezeichnete D/A-Wandler für die Wandlung eines Vier-Bit-Datenworts vorgesehen ist. Die Stromquellentransistoren TO - T4 werden gemeinsam an ihrer Basis durch einen Ausgang des gemeinsamen Referenzstromkreises RF gesteuert, welcher für die Einregelung eines konstanten Basispotentials sorgt. Das die Emittervorspannungen liefernde R/2R-Netzwerk ist in der aus Fig. 1 ersichtlichen Weise an den Emitter des einzelnen Stromquellentransistors angeschlossen, so daß die Transistoren TO und T1 jeweils einen Widerstand 2R als Emittervorwiderstand haben, während T2 einen Emittervorwiderstand im Werte von 3R, T3 im Werte von 4R und T4 im Werte von 4R hat.

Die Stromquelle TO dient zur Stromversorgung des Referenzstromkreises RF, der in üblicher Weise, z.B. als Operationsverstärker, ausgebildet ist. Der Stromquellentransistor T1 ist mit seinem Kollektor an einen durch zwei emittergekoppelten und einander gleichen npn-Transistoren gegebenen Differenzverstärker, der als Umschalter U1 dient, angeschlossen. Das gleiche gilt für den Kollektor von T2 inbezug auf

0140086

den Umschalter U2 und hinsichtlich des Transistors T3 inbezug auf den Umschalter U3. Hingegen hat der zum Stromquellentransistor T4 gehörende Umschalter U4 noch einen weiteren Transistor, dessen Emitter am Emitter der beiden anderen Transistoren in U4 liegt. Diese beiden Transistoren T5 und T6 entsprechen in ihrer Anschaltung den beiden Transistoren der übrigen Umschalter U1 - U3, wobei die Basis von T5 durch das zugehörige Bit $b_4$ gesteuert und sein Kollektor - gemeinsam mit dem Kollektor der entsprechenden Transistoren der übrigen Umschalter - mit Masse verbunden ist, während der Kollektor von T6 zum gemeinsamen Ausgang des Wandlers führt und an seiner Basis gemeinsam mit den Basen der entsprechenden Transistoren der übrigen Umschalter gesteuert ist. Der Kollektor des dritten Transistors T7, der in den anderen Umschaltern kein Analogon hat, liegt an Masse und wird an seiner Basis gemeinsam mit denjenigen Transistoren (und damit mit T6) gesteuert, deren Kollektor am Wandlerausgang liegt.

Hinsichtlich der Stromquellentransistoren T1 - T3 der bekannten Schaltung nach Fig. 1 kann nun festgestellt werden, daß durch die Verwendung des gezeichneten invertierenden Netzwerks die Ströme durch diese Transistoren dual gewichtet sind, vorausgesetzt, daß die Transistoren dieselbe Kennlinie $I_E = f(U_{BE})$ aufweisen. Da diese Transistoren jedoch verschiedene Ströme führen, könnte man wegen der Abhängigkeit der Basis-Emitterspannung von der Stromdichte eine Übereinstimmung der effektiven Kennlinien nicht erwarten. Um diesem Rechnung zu tragen, ist eine duale Abstufung der Emitterflächen der Stromquellentransistoren vorgesehen, was durch die Anzahl der Emitterpfeile bei den einzelnen Stromquellentransistoren angezeigt ist. Der Stromquellentransistor TO läßt über seinen Emittervorwiderstand einen Referenzstrom $I_o$ einfließen. Ändern sich z.B. durch Temperatureinfluß die absoluten Teilströme $I_1 - I_3$, so ändert sich auch der Strom $I_o$. Dieser wird jedoch im Referenzstromkreis RF überwacht und auf einen Sollwert eingeregelt, was

0140086

dann auch für die übrigen Stromquellentransistoren der in Fig. 1 dargestellten Schaltung gilt.

Hat nun der Wandler eine höhere Anzahl von durch je ein Bit zu beaufschlagenden Stufen, so werden bei den Stromquellen für die Stufen der niedrigsten Bitwertigkeit die gelieferten Konstantströme und damit die Spannungsabfälle an den zugehörigen Emitterwiderständen sehr klein. Um dem Rechnung zu tragen fließt bei der bekannten Ausgestaltung gemäß Fig. 1 im letzten Transistor T4 der gleiche Strom wie in T3. Die Halbierung des Stroms $I_4$ erfolgt erst im Umschalter U4. Da nun die die Umschalter U1 - U4 bildenden Transistoren identische Eigenschaften haben (und dies auch hinsichtlich der Transistoren T5, T6 und T7 im Umschalter U4 gilt) fließt der Strom $I_4$ entweder durch T5 nach Masse oder er verteilt sich gleichmäßig auf T6 und T7, wobei jedoch nur T6 an den Ausgang des Wandlers führt. Dieser erhält also von der letzten Stufe nur einen Stromanteil $I4 = I3/2$.

Hinsichtlich der von der Erfindung zu lösenden Aufgabe ist nun folgendes festzustellen:

Digital/Analogwandler haben bekanntlich die Aufgabe, ein meist binär codiertes Datenwort in einen dem Zahlenwert des Datenworts entsprechenden Strom $I_A$ oder in eine diesem Zahlenwert entsprechende Spannung umzusetzen. Dabei werden gewöhnlich, wie auch bei der üblichen Ausgestaltung gemäß Fig. 1, den einzelnen Stellen des Datenworts zugeordnete Stromschalter umgeschaltet. Die binäre Wichtung kann dabei vor oder nach den Umschalterstufen vorgenommen werden. Im ersten Fall fließen in allen Stromschalterstufen dieselben Stromwerte und werden z.B. in einem Widerstandsnetzwerk gewichtet und in Spannungen umgewandelt. Dieses Verfahren hat bei schnelleren Wandlern den Nachteil höherer Kapzitätswirkungen am Ausgang des Wandlers. Bei einer vor den Umschaltern erfolgenden Wichtung muß die Schaltung derart ausgestaltet sein, daß die die Stromumschalterstufen versorgenden Stromquellen über den ganzen spezifizierten Temperaturbereich im richtigen Verhältnis gewichtete Ströme liefern, worauf bei der bekannten Schaltung nach Fig. 1 bereits Rücksicht genommen ist.

Wie nun aus Fig. 1 ersichtlich, werden bei den bekannten D/A-Wandlern die Stromquellen mit Bipolartransistoren und Emitterwiderständen realisiert. Die Basisanschlüsse der Stromquellentransistoren werden, wie aus Fig. 1 ersichtlich, mit einer gemeinsamen Steuerspannung beaufschlagt. Die Wichtung erfolgt aufgrund einer entsprechenden Einstellung der Emitterflächenverhältnisse und der Emittervorwiderstandsverhältnisse. Da jedoch - vor allem bei einer monolithischen Realisierung des Wandlers - ein Emitterflächenverhältnis zwischen zwei (sonst gleichen) Transistoren, das größer als $2^4$ ist, sich nicht sinnvoll realisieren läßt, muß bei Wandlern für längere Datenworte eine andere Lösung angewendet werden.

Eine bekannte Möglichkeit hierzu besteht darin, daß man das Widerstandsnetzwerk nach den Stromschaltern anordnet. Dies kann so geschehen, daß jede Stufe den gleichen Strom in einen eigenen Knoten einspeist. Eine Alternative hierzu ist dann gegeben, wenn mehrere gewichtete Stromquellen an einem gemeinsamen Knoten hängen und dieser Knoten über ein Stromteilernetzwerk mit einem anderen Knoten verbunden ist, der seinerseits ebenfalls mit gewichteten Stromquellen gespeist ist.

Eine andere Möglichkeit wird in der US-PS 4,055,773 beschrieben. Hier werden Ströme der ersten vier Stufen mit einem R/2R-Netzwerk an der an der Emitterseite der Stromquellentransistoren gewichtet. Die letzte Stromquelle ist (wie auch bei der Schaltung nach Fig. 1) doppelt ausgeführt, wobei eine davon den Strom aus einem weiteren R-2R-Netzwerk zieht, das seinerseits wiederum eine Emitterbeschaltung von mehreren Stromquellen darstellt.

Die Gewichtung kann auch, wie bereits erwähnt und bei der Schaltung nach Fig. 1 angewendet, durch fortlaufende Halbierung der Emitterfläche und Verdopplung des Emitterwiderstands erreicht werden. Nach vier- bis fünffacher Wichtung kann dann - anstatt die minimal realisierbare Emitterfläche zu unterschreiten - die entsprechend um $U_T \cdot \ln 2$ niedriger erforderliche Basis-Emitterspannung durch Hinzuschalten eines zusätzlichen Emitterwiderstands erhalten werden. Dabei ist jedoch festzustellen, daß sich aufgrund der Temperaturabhängigkeit der Kennlinie der Transistoren die Spannungsdifferenz $U_T = (k \cdot T)/e$ (k = Boltzmannkonstante, e = Elementarladung, T = absolute Temperatur, $U_T$ = Temperaturspannung) gemäß der angegebenen Beziehung für $U_T$ ändert, was auch für die bekannte Schaltung nach Fig. 1 gilt. Man erkennt nunmehr, daß wegen $d(kT/e)/dT = k/e$ eine lineare Änderung mit einer Änderung der absoluten Temperatur des betreffenden Transistorbereichs unausbleiblich ist und daß ein Ausgleich sich nicht ausschließlich durch Abstufung der Emitterflächen im Sinne wachsender Größe des zu erzeugenden Konstantstroms erreichen läßt. In diesem Sinne ist also auch die bekannte Schaltung nach Fig. 1 verbesserungsbedürftig.

Es ist Aufgabe der Erfindung, eine hierzu geeignete Ausgestaltung eines D/A-Wandlers anzugeben.

Hierzu ist gemäß der Erfindung ein Digital/Analogwandler der eingangs definierten Art derart ausgestaltet, daß zwar bei allen Wandlerstufen eine Wichtung des Emittervorwiderstands des Stromquellentransistors der betreffenden Stufe nach Maßgabe des die betreffende Stufe beaufschlagenden Bits aus dem zu wandelnden Datensignal vorgesehen ist, daß aber hinsichtlich der Wichtung der Emitterflächen der in den Wandlerstufen vorgesehenen Stromquellentransistoren eine Aufteilung der Wandlerstufen in zwei Gruppen derart vorgenommen ist, daß sich die Wichtung der Emitterflächen

0140086

nur auf die Stromquellentransistoren der zu den höheren Bitwertigkeiten gehörenden ersten Gruppe von Wandlerstufen beschränkt, während die Stromquellentransistoren der den niedrigen Bitwertigkeiten zugeordneten zweiten Gruppe von Wandlerstufen alle bezüglich der Ausgestaltung der Stromquellentransistoren übereinstimmen und eine Emitterfläche haben, die mit der Emitterfläche eines einen niedrigen Strom liefernden Stromquellentransistors aus der ersten Gruppe übereinstimmt, daß dabei zur gemeinsamen Steuerung der Basisanschlüsse der zur ersten Gruppe von Wandlerstufen gehörenden Stromquellentransistoren zwei die Steuerung durch den Ausgang des Referenzstromkreises vermittelnde weitere Transistoren vorgesehen sind, von denen der erste Transistor an seiner Basis durch den Ausgang des Referenzstromkreises und der zweite Transistor gemeinsam mit dem Basisanschluß der Stromquellentransistoren der ersten Gruppe von Wandlerstufen an seiner Basis durch den Emitter des ersten Transistors gesteuert ist und beide Transistoren mit den Stromquellentransistoren bezüglich des Leitungstyps von Emitter, Basis und Kollektor übereinstimmen, daß außerdem der Kollektor des ersten Transistors an den Eingang einer - mit ihrem Fußpunkt an der Klemme für das Bezugspotential für den Wandler liegenden und aus zu den beiden Transistoren komplementären Transistoren aufgebauten - ersten Stromspiegelschaltung und der Kollektor des zweiten Transistors an dem durch den von einer Referenzspannungsquelle gelieferten Referenzstrom beaufschlagten Eingang des Referenzstromkreises liegen, während der Emitter des ersten Transistors als auch der Emitter des zweiten Transistors über je einen Emittervorwiderstand an die Klemme für das Versorgungspotential gelegt und dabei der Emittervorwiderstand des zweiten Transistors dem Emittervorwiderstand eines der niedrigeren Bitwertigkeit zugeordneten Stromquellentransistors in der ersten Gruppe der Wandlerstufen gleich ist, daß ferner die Emitterfläche der Stromquellentransistoren der zweiten Gruppe von Wandlerstufen gleich der Emitterfläche des Stromquellentran-

sistors der niedrigsten Bitwertigkeit in der ersten Gruppe von Wandlerstufen eingestellt ist und jedem Stromquellentransistor der zweiten Gruppe von Wandlerstufen je ein Ausgangstransistor einer zweiten Stromspiegelschaltung sowie je ein durch den Ausgang des Referenzstromkreises gesteuerter Vermittlungstransistor zugeordnet ist, daß dabei sowohl die die zweite Stromspiegelschaltung bildenden Transistoren als auch die Vermittlungstransistoren vomselben Typ wie die Stromquellentransistoren in den vorgesehenen Wandlerstufen, insbesondere vom npn-Typ, sind, und außerdem der Fußpunkt der zweiten Stromspiegelschaltung durch die Klemme für das Versorgungspotential gegeben ist, daß weiterhin die Ausgangstransistoren der zweiten Stromspiegelschaltung einander gleich und mit ihrem Kollektor an die Basis je eines Stromquellentransistors der zweiten Gruppe von Wandlerstufen gelegt sind, während die an ihrer Basis durch den Ausgang des Referenzstromkreises gesteuerten und zuletzt genannten Vermittlungstransistoren mit ihrem Kollektor an der Klemme für das Bezugspotential und mit ihrem Emitter an der Basis je eines Stromquellentransistors der zweiten Gruppe von Wandlerstufen liegen und daß schließlich die Emitterflächen der zuletzt genannten und zur Steuerung der Stromquellentransistoren der zweiten Gruppe von Wandlerstufen dienenden Vermittlungstransistoren nach Maßgabe der Bitwertigkeit der von ihnen jeweils gesteuerten Stromquellentransistoren dual gewichtet sind und außerdem der Ausgang der ersten Stromspiegelschaltung mit dem Eingang der zweiten Stromspiegelschaltung verbunden ist.

Dabei ist insbesondere vorgesehen, daß die Stromquellentransistoren in den Wandlerstufen als npn-Transistoren ausgebildet sind, so daß die Transistoren des zweiten Stromspiegels ebenfalls npn-Transistoren und die Transistoren des ersten Stromspiegels pnp-Transistoren sind. Ferner besteht bevorzugt der Referenzstromkreis aus einem in Bipolartechnik ausgeführten Operationsverstärker.

0140086

Eine der soeben gegebenen Definition der Erfindung entsprechende Schaltung für einen Digital/Analogwandler ist in Fig. 2 dargestellt.

Hier ist zunächst zu bemerken, daß - im Gegensatz zu Fig. 1 - auf die Darstellung von Details der Umschalter verzichtet worden ist. Die in Fig. 2 dargestellte Schaltung entspricht einem Digital/Analogwandler mit acht Wandlerstufen, deren Stromquellentransistoren Q0 - Q7 z.B. in der aus Fig. 1 ersichtlichen Weise an je einen als emittergekoppelte Differenzstufe ausgebildeten Umschalter U0,...U7 einerseits an den gemeinsamen Ausgang des Wandlers und andererseits an die Klemme für das Bezugspotential GND anlegbar ist. Der Hauptteil des Referenzstromkreises RF wird durch einen - z.B.ebenfalls in npn-Bipolartechnik ausgestalteten - Operationsverstärker OP gebildet, dessen invertierender Eingang an der Klemme für das Bezugspotential GND liegt und dessen nichtinvertierender Eingang den Eingang für den Referenzstrom $I_{REF}$ bildet. Hierzu ist der nichtinvertierende Eingang des Operationsverstärkers OP über einen Widerstand $R_{REF}$ an den einen Pol einer Referenzspannungquelle $U_{REF}$ gelegt, deren anderer Pol ebenfalls an der Klemme für das Bezugspotential GND liegt.

Bei der in Fig. 2 dargestellten Schaltung gemäß der Erfindung für einen D/A-Wandler sind, wie bereits erwähnt, die verwendeten Stromquellentransistoren Q0 - Q7 alle vom npn-Typ, wobei der Wert ihrer Emitterflächen durch den mit dem Zeichen "x" versehenen jeweiligen Zahlenwert (der mit der Emittergrundfläche, also der Emitterfläche des Stromquellentransistors Q0 der mit der niedrigsten Bitwertigkeit zu beaufschlagenden Wandlerstufe zu multiplizieren ist, um die effektive Emitterfläche zu erhalten) angegeben ist. Die an den Emittervorwiderständen angegebenen Zahlenwerte n·R beziehen sich auf den Wert des Widerstands R bei der der höchsten Bitwertigkeit zugeordneten Wandlerstufe, d.h. also des Emittervorwiderstands ihres Stromquellentransistors Q7. Die von den einzelnen Stromquellentransistoren an das jeweils zugehörige Umschaltwerk
gelieferten Ströme sind in ähnlicher Weise wie in Fig. 2
bezeichnet.

Der Ausgang des Operationsverstärkers OP liegt bei der in
Fig. 2 dargestellten Schaltung für einen D/A-Wandler an der
Basis eines ersten npn-Transistors Q13, dem als Emitterfolger ein zweiter npn-Transistor Q14 nachgeschaltet ist. Der
Emitter des ersten npn-Transistors Q13 liegt über einen
Widerstand RS an der Klemme für das Versorgungspotential
$V_{EE}$ an der Basis des zweiten Transistors Q14 und an den
Basisanschlüssen der Stromquellentransistoren Q3 - Q7, die
sich durch gewichtete Emitterflächen voneinander unterscheiden und daher zur ersten Gruppe der Wandlerstufen gehören.
Außerdem liegt der Kollektor des die Steuerung der Stromquellentransistoren Q3 - Q7 durch den Operationsverstärker
OP und damit durch den Referenzstromkreis RF vermittelnden
ersten npn-Transistors Q13 am Eingang des ersten Stromspiegels Q29, Q30, Q31 entsprechend der oben gegebenen Definition der Erfindung.

Im Prinzip kann für die zu verwendenden Stromspiegel jede
bekannte Stromspiegelschaltung eingesetzt werden, sofern sie
im Falle des ersten Stromspiegels unter Verwendung von pnp-
Transistoren und im Falle des zweiten Stromspiegels unter
Verwendung von npn-Transistoren aufgebaut ist. Im vorliegenden Fall ist, wie aus Fig. 2 ersichtlich, eine sog. verbesserte Stromspiegelschaltung verwendet. Sie besteht aus den
beiden mit ihrem Emitter am Bezugspotential GND liegenden
pnp-Transistoren Q29 und Q30, die mit ihren Basisanschlüssen mit einander sowie mit dem Emitter des dritten pnp-
Transistors Q31 verbunden sind. Der Kollektor des Transistors Q30 bildet den Ausgang der ersten Stromspiegelschaltung, während der Kollektor des Transistors Q29 sowie die
Basis des Transistors Q31 gemeinsam den (den durch den Kollektor von Q13 beaufschlagten) Eingang der ersten Stromspiegelschaltung bilden. Zu erwähnen ist noch, daß der Kollektor des pnp-Transistors Q31 mit der Klemme für das Versorgungspotential $V_{EE}$ verbunden ist. Außerdem liegt – entsprechend der oben gegebenen Definition der Erfindung – der den Ausgang der ersten Stromspiegelschaltung bildende Kollektor von Q30 am Eingang der zweiten Stromspiegelschaltung.

Der Fußpunkt der aus npn-Transistoren gebildeten zweiten Stromspiegelschaltung ist durch die Klemm für das Versorgungspotential $V_{EE}$ gegeben. Der Eingangstransistor Q25 ist durch Kurzschluß zwischen seinem Kollektor und seiner Basis als Diode geschaltet und liegt mit seinem Emitter an $V_{EE}$, während seine Basis und sein Kollektor einerseits mit dem Kollektor des Ausgangstransistors des ersten Stromspiegels, also des Transistors Q30, und außerdem mit dem Basisanschluß der in der zweiten Stromspiegelschaltung vorgesehenen Ausgangstransistoren Q26, Q27 und Q28 unmittelbar verbunden ist. Es handelt sich also bei der zweiten Stromspiegelschaltung um einen einfachen Stromspiegel mit drei durch den Kollektor je eines der drei Ausgangstransistoren Q26, Q27 und Q28 gegebenen Ausgang, der entsprechend der Definition der Erfindung durch npn-Transistoren gebildet ist.

Gemäß der Erfindung sind nun die einzelnen Wandlerstufen in zwei Gruppen aufgeteilt. Die den höheren Bitwertigkeiten des Wandlers zugeordneten Wandlerstufen mit den Stromquellentransistoren Q3 - Q7 umfaßt im Beispielsfalle sechs Stufen, während die den niedrigen Bitwertigkeiten zugeordnete zweite Gruppe von Wandlerstufen im Beispielsfall gemäß Fig. 2 die drei Stufen mit den Bitwertigkeiten 1, 2 und 4 umfaßt, die die Stromquellentransistoren Q0, Q1 und Q2 enthalten.

Für die Steuerung der Stromquellentransistoren Q3 - Q7 (also allgemein der Stromquellentransistoren der ersten Gruppe von Wandlerstufen) dient der Emitter des an seiner Basis durch den Ausgang des Operationsverstärkers OP gesteuerten und in der bereits beschriebenen Weise mit seinem Kollektor am Eingang der ersten Stromspiegelschaltung Q29, Q30 und Q31 liegenden Transistors, indem, wie bereits beschrieben, der Emitter dieses Transistors Q13 mit dem Basisanschluß der Stromquellentransistoren Q3 - Q7 der ersten Gruppe von Wandlerstufen unmittelbar verbunden ist. Dabei ist hinsichtlich des ebenfalls an seiner Basis von ihm gesteuerten zweiten npn-Transistors Q14 noch zu erwähnen, daß dieser Transistor in dem gezeichneten Beispielsfall hinsichtlich der Wichtung seines Emittervorwiderstands und hinsichtlich seiner Emitterfläche dem dem zweitniedrigsten Bit der ersten Gruppe von Wandlerstufen zugeordneten Stromquellentransistoren Q4 gleich ist, wie dies auch in Fig. 2 angegeben ist, und daß außerdem der Kollektor dieses Transistors Q14 unmittelbar mit dem nichtinvertierenden Eingang des Operationsverstärkers OP verbunden ist.

Für die Steuerung der Stromquellentransistoren Q0 - Q2 der Wandlerstufen in der zweiten Gruppe dient nun je ein Vermittlungstransistor Q22, Q23, Q24 vom npn-Typ, der an seiner Basis - entsprechend dem Transistor Q13 - durch den Ausgang des Operationsverstärkers OP beaufschlagt ist. Dies geschieht, indem (abweichend vom Transistor Q13) diese Vermittlungstransistoren Q22 -Q24 mit ihrem Kollektor an der Klemme für das Bezugspotential GND liegen und mit ihrem Emitter nicht nur an der Basis je eines der in der zweiten Gruppe von Wandlerstufen vorgesehenen Stromquellentransisistors Q0 - Q2 sondern auch am Kollektor je eines der in der zweiten Stromspiegelschaltung vorgesehenen Ausgangstransistoren Q26, Q27 und Q28 liegen. Außerdem hat die Emitterfläche des der Wandlerstufe Q0 mit dem niedrigsten Konstantstromwert zugeordneten Vermittlungstransistors Q24 dieselbe Emitterfläche wie die Stromquellentransistoren Q0 - Q2 und der Stromquellentransistor Q3 (also die Stromquellentransistoren der zweiten Gruppe und der Stromquellentransistor der niedrigsten Bitwertigkeit in der ersten Gruppe von Wandlerstufen). Der der nächst höheren Bitwertigkeit in der zweiten Gruppe zugeordnete Stromquellentransistor Q1 wird von dem Vermittlungstransistor Q23 gesteuert, dessen Emitterfläche doppelt so groß wie die der Stromquellentransistoren Q0 - Q3 ist, während der der höchsten Bitwertigkeit in der zweiten Wandlerstufengruppe zugeordnete Stromquellentransistor Q2 durch den die vierfache Emitterfläche im Vergleich zu der Emitterfläche von Q0 - Q3 aufweisenden Vermittlungstransistor Q22 gesteuert wird. Hinsichtlich der Wichtung der Emittervorwiderstände kann auf die aus Fig. 2 ersichtlichen Werte hingewiesen werden.

Die Wirkung der in Fig. 2 dargestellten Schaltung gemäß der Erfindung ist nun, wie folgt:

Die Stromquellentransistoren der ersten Gruppe, also Q3 - Q7, werden über den Emitterfolger Q13 vom Operationsverstärker OP geregelt. Der Operationsverstärker OP bezieht seine Eingangsspannung von einem Spannungsabfall, der durch den als Referenzstromquelle wirkenden Transistor Q14 am Referenzwiderstand $R_{REF}$ im Referenzstromkreis RF erzeugt wird.

Die Emitterflächen der Stromquellentransistoren Q3 - Q7 sind ebenso wie die Emittervorwiderstände dieser Transistoren binär gewichtet. Bei den Stromquellentransistoren Q0 - Q2 sind zwar die Emitterwiderstände aber nicht die Emitterflächen gewichtet. Um dennoch eine Wichtung der Ströme I0, I1 und I2 zu erreichen, muß die Basis des Transistors Q2 mit $UQ-UT \cdot ln2$, die des Transistors Q1 mit $UQ - UT \cdot ln4$ und die Basis von Q2 mit $UQ - UT \cdot ln8$ gesteuert werden. Wie aus Fig. 2 ersichtlich liegt UQ um $U_{BE}$ von Q13 unter dem Basispotential von Q13. Läßt man durch Q22, dessen Basis mit der von Q13 verbunden ist, und der die halbe Emitterfläche von Q13 besitzt, den glei-

0140086

chen Emitterstrom wie durch Q13 fließen, so gilt

$$U_{BE}(Q22) = U_{BE}(Q13) + U_T \cdot \ln 2.$$

Damit bietet sich der Emitter von Q22 zur Steuerung der Stromquelle Q2 an. Das Prinzip wird an den Stromquellen Q1 und Q0 wiederholt angewendet.

Das Ziel, durch Q22, Q23 und Q24 denselben Emitterstrom wie durch Q13 fließen zu lassen, erreicht man durch die beiden Stromspiegelschaltungen.

Gegebenenfalls kann zur Kompensation des Earlyeffekts am Kollektor von Q30 im ersten Stromspiegel eine Diodenserienschaltung (nicht gezeichnet) zwischen Q30 und Q25 zweckmäßig sein.

Die beschriebene Ausführungsform des erfindungsgemäßen D/A-Wandlers kann durch Verwendung anderer üblicher Stromspiegelschaltungen abgewandelt werden, wobei in allen Fällen der erste Stromspiegel mit den Transistoren aufzubauen ist, die zu den Stromquellentransistoren in den Wandlerstufen komplementär, und der zweite Stromspiegel mit Transistoren aufzubauen ist, die vomselben Typ wie die Stromquellentransistoren sind. Außerdem kann man die Anzahl der Wandlerstufen in den beiden Gruppen unter Beachtung des aus der Fig. 2 und der Definition der Erfindung ersichtlichen Prinzips ändern.

2 Figuren
4 Patentansprüche

0140086

VPA 83 P 5302 E

Patentansprüche

1.) Integrierbarer Digital/Analogwandler in Bipolartechnik, bei dem jedem Bit des zu verarbeitenden digitalen Datensignals je eine aus einem als Konstantstromquelle betriebenen Transistor und aus einem Umschalter bestehende Stufe zugeordnet ist und die einzelnen Wandlerstufen derart ausgebildet sind, daß beim Zustand logisch "1" des die betreffende Stufe beaufschlagenden Bits der den Ausgang der Konstantstromquelle bildende Kollektor des Stromquellentransistors an den Signalausgang des Wandlers und beim Zustand logisch "0" dieses Bits an einen gemeinsamen anderen Anschluß, z.B. an den Versorgungsanschluß für das Bezugspotential, gelegt wird, bei dem ferner der vom Stromquellentransistor an den zugehörigen Umschalter in den vorgesehenen Stufen des Wandlers nach Maßgabe der Bitwertigkeit des die einzelne Stufe beaufschlagenden Bits in dem auszuwertenden digitalen Datenwort durch entsprechende unterschiedliche Bemessung des den Emitter des Stromquellentransistors mit der Versorgungsklemme für das Emitterpotential $V_{EE}$ des Wandlers verbindenden Emittervorwiderstands eine dieser Bitwertigkeit entsprechende Wichtung erhält und bei dem schließlich die Stromquellentransistoren in den vorgesehenen Stufen zwar bezüglich der Dotierung von Emitter, Basis und Kollektor über einstimmen, während andererseits auch eine Wichtung hinsichtlich der Emitterfläche der Stromquellentransistoren - und zwar im gleichen Sinn wie die Wichtung des von den Stromquellentransistoren gelieferten Konstantstroms - vorgesehen ist, dadurch gekennzeichnet, daß zwar bei allen Wandlerstufen eine Wichtung des Emittervorwiderstands des Stromquellentransistors ($Q_i$; i = 0, 1, 2,.....n(z.B. n =7)) nach Maßgabe des die betreffende Stufe beaufschlagenden Bits aus dem zu wandelnden Digitalsignal vorgesehen ist, daß aber hinsichtlich der Wichtung der Emitterflächen der in den Wandlerstufen vorgesehenen Stromquellentransistoren ($Q_i$) eine Aufteilung der Wandlerstufen in zwei Gruppen derart vorgenommen ist, daß sich die Wichtung der Emitterflächen nur auf die Stromquellentransistoren (Q3 - Q7) der zu den höheren Bitwertigkeiten gehörenden ersten Gruppe von Wandlerstufen beschränkt, während die Stromquellentransistoren (Q0-Q2) der den niedrigen Bitwertigkeiten zugeordneten zweiten Gruppe von Wandlerstufen alle bezüglich der Ausgestaltung der Stromquellentransistoren übereinstimmen und eine Emitterfläche haben, die mit der Emitterfläche eines einen niedrigen Strom liefernden Stromquellentransistors (Q3) aus der ersten Gruppe übereinstimmt, daß dabei zur gemeinsamen Steuerung der Basisanschlüsse der zur ersten Gruppe von Wandlerstufen gehörenden Stromquellentransistoren zwei die Steuerung durch den Ausgang (OP) des Referenzstromkreises (RF) vermittelnde weitere Transistoren (Q13, Q14) vorgesehen sind, von denen der erste Transistor (Q13) an seiner Basis durch den Ausgang (OP) des Referenzstromkreises (RF) und der zweite Transistor (Q14) gemeinsam mit dem Basisanschluß der Stromquellentransistoren (Q3 -Q7) der ersten Gruppe von Wandlerstufen an seiner Basis durch den Emitter des ersten Transistors (Q14) gesteuert ist und beide Transistoren (Q13, Q14) mit den Stromquellentransistoren (Q0-Q7) bezüglich des Leitungstyps von Emitter, Basis und Kollektor übereinstimmen, daß außerdem der Kollektor des ersten Transistors (Q13) an den Eingang einer - mit ihrem Fußpunkt an der Klemme für das Bezugspotential (GND) für den Wandler liegenden und aus zu den beiden Transistoren (Q13, Q14) komplementären Transistoren (Q29 - Q31) aufgebauten - ersten Stromspiegelschaltung und der Kollektor des zweiten Transistors (Q14) an dem durch den von einer Referenzspannungsquelle (UREF) gelieferten Referenzstrom (IREF) beaufschlagten Eingang des Referenzstromkreises (RF) liegen, während der Emitter des ersten Transistors (Q13) als auch der Emitter des zweiten Transistors (Q14) über je einen Emittervorwiderstand (R5, 8R) an die Klemme für das Versorgungspotential ($V_{EE}$) gelegt und dabei der Emittervorwiderstand (8R) des zweiten Transistors (Q14) den Emittervorwiderstand eines der niedrigeren Bitwertigkeit zugeordneten Stromquellentransistors (Q4) in der ersten Gruppe der Wandlerstufen gleich ist, daß ferner die Emitter-fläche der Stromquellentransistoren (Q0-Q2) der zweiten Gruppe von Wandlerstufen gleich der Emitterfläche des Stromquellentransistors (Q3) der niedrigsten Bitwertigkeit in der ersten Gruppe von Wandlerstufen eingestellt ist und jedem Stromquellentransistor (Q0-Q2) der zweiten Gruppe von Wandlerstufen je ein Ausgangstransistor (Q22 - Q24) einer zweiten Stromspiegelschaltung (Q25 - Q28) sowie je ein durch den Ausgang (OP) des Referenzstromkreises (RF) gesteuerter Vermittlungstransistor (Q22 - Q24) zugeordnet ist, daß dabei sowohl die die zweite Stromspiegelschaltung bildenden Transistoren (Q25 - Q28) als auch die Vermittlungstransistoren (Q22- Q24) vomselben Typ wie die Stromquellentransistoren (Q0-Q7) in den vorgesehenen Wandlerstufen sind und außerdem der Fußpunkt der zweiten Stromspiegelschaltung durch die Klemme für das Versorgungspotential ($V_{EE}$) gegeben ist, daß weiterhin die Ausgangstransistoren (Q22 - Q24) der zweiten Stromspiegelschaltung einander gleich und mit ihrem Kollektor an die Basis je eines Stromquellentransistors (Q0-Q2) der zweiten Gruppe von Wandlerstufen gelegt sind, während die an ihrer Basis durch den Ausgang des Referenzstromkreises (RF) gesteuerten und zuletzt genannten Vermittlungstransistoren (Q22 - Q24) mit ihrem Kollektor an der Klemme für das Bezugspotential (GND) und mit ihrem Emitter an der Basis je eines Stromquellentransistors (Q0-Q2) der zweiten Gruppe von Wandlerstufen liegen, und daß schließlich die Emitterflächen der zuletzt genannten und zur Steuerung der Stromquellentransistoren (Q0-Q2) der zweiten Gruppe von Wandlerstufen dienenden Vermittlungstransistoren (Q22 -Q24) nach Maßgabe der Bitwertigkeit der von ihnen jeweils gesteuerten Stromquellentransistoren (Q0-Q2) dual gewichtet sind und außerdem der Ausgang (Q30) der ersten Stromspiegelschaltung mit dem Eingang (Q25) der zweiten Stromspiegelschaltung verbunden ist.

2.) Digital/Analogwandler nach Anspruch 1, dadurch gekennzeichnet, daß die Stromquellentransistoren (Q0-Q7) in den Wandlerstufen npn-Transistoren sind.

3.) Digital/Analogwandler nach Anspruch 1 oder 2, dadurch gekennzeichnet, daß die Emitterfläche sowie der Emittervorwiderstand des zweiten der zur Steuerung der Stromquellentransistoren (Q3-Q7) der ersten Gruppe von Wandlerstufen dienenden Vermittlungstransistors (Q14) in gleicher Weise wie beim Stromquellentransistor (Q4) der der zweitniedrigsten Bitwertigkeit zugeteilten Stufe in der ersten Gruppe von Wandlerstufen bemessen sind.

4.) Digital/Analogwandler nach einem der Ansprüche 1 bis 3, dadurch gekennzeichnet, daß der Eingang der zweiten Stromspiegelschaltung durch einen Transistor (Q25) mit kurzgeschlossenem Kollektor-Basis-Übergang gebildet ist, während der Eingang der ersten Stromspiegelschaltung durch einen Transistors (Q29) gegeben ist, dessen Basis-Kollektorübergang durch den Emitter-Basis-Übergang eines zweiten - gleichen - Transistors (Q31) überbrückt und der Kollektor dieses weiteren Transistors (Q31) an die Klemme für das Versorgungspotential ($V_{EE}$) angeschlossen ist.

0140086

1 / 1

FIG 1

FIG 2